Europäisches Patentamt

European Patent Office

Office européen des brevets

(11) Publication number: **0 642 227 A1**

# EUROPEAN PATENT APPLICATION

(21) Application number: **94113962.8**

(22) Date of filing: **06.09.94**

(51) Int. Cl.⁶: **H03L 7/089**, H03L 7/093

(30) Priority: **07.09.93 JP 221572/93**

(43) Date of publication of application:
**08.03.95 Bulletin 95/10**

(84) Designated Contracting States:
**DE FR GB**

(71) Applicant: **NEC CORPORATION**
**7-1, Shiba 5-chome**
**Minato-ku**
**Tokyo (JP)**

(72) Inventor: **Fujii, Takashi, c/o NEC Corporation**
**7-1, Shiba 5-chome, Minato-ku**
**Tokyo (JP)**

(74) Representative: **Baronetzky, Klaus, Dipl.-Ing.**
**et al**
**Patentanwälte**
**Dipl.-Ing. R. Splanemann, Dr. B. Reitzner,**
**Dipl.-Ing. K. Baronetzky**
**Tal 13**
**D-80331 München (DE)**

(54) **Charge-pump phase-lock loop circuit.**

(57) The invention provides a circuitry comprising an oscillator (1) for oscillating an electric signal, a comparator (14) being electrically connected to the oscillator (1) for fetching the electric signal from the oscillator (1) and subsequent comparison in phase of an external input signal with the electric signal for generation of a detecting signal according to a result of the comparison, a charge-pump (13) including first and second current sources (50,51) being electrically connected in parallel to the comparator (14) for fetching the detecting signal from the comparator (14) and subsequent generation of first and second pump currents by the first and second current sources (50,51) respectively on the basis of the detecting signal and a filter (12,22) being electrically connected to the oscillator (1) and the charge-pump (13) for fetching the pump currents from the charge-pump (13) and subsequent smoothing of the pump current to be supplied to the oscillator (1) thereby controlling the electric signal to match the electric signal to the external input signal by a negative feedback. This allows for an independent selection of the damping factor and of the natural frequency of the phase-locked loop.

**FIG. 3**

This invention relates to a phase-lock loop circuit, and more particularly to a charge-pump phase-lock loop circuit which can readily be constructed by use of small resistance and capacitance.

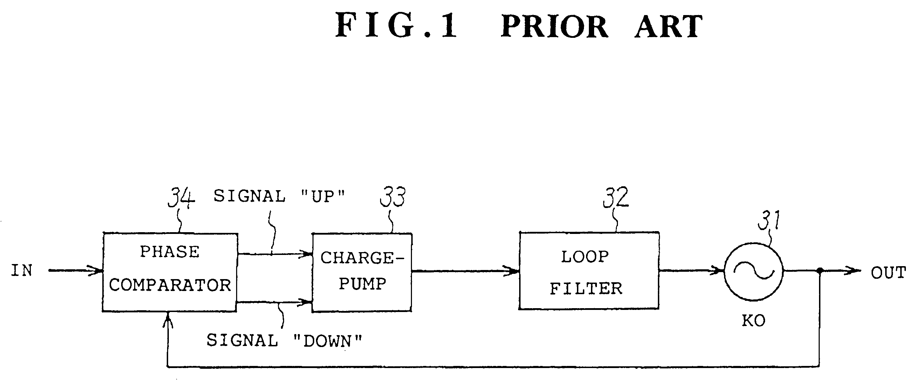

A charge-pump phase-lock loop circuit is suitable for a metal oxide semiconductor integrated circuit. The construction of the charge-pump phase-lock loop circuit is disclosed in "Charge-Pump Phase-Lock Loops," IEEE TRANSACTION ON COMMUNICATIONS, VOL. COM-28, NO. 11, NOVEMBER 1980. Fig. 1 shows a conventional charge-pump phase-lock loop circuit. The conventional charge-pump phase-lock loop circuit comprises a voltage-controlled oscillator 31 controlled by a control voltage, a phase comparator 34 for detecting a difference in phase between an external input signal "IN" and an output signal "OUT" of the voltage-controlled oscillator 31, a charge-pump 33 for generating a pump current on the basis of an output signal of the phase comparator 34 and loop filter 32 for smoothing the pump current of the charge-pump 33 to generate the control voltage for the voltage-controlled oscillator 34.

In operation, an external input signal "IN" and an output signal "OUT" from the voltage-controlled oscillator 31 are compared by the phase comparator 34. As a result of this comparison, a signal "UP" is supplied from the phase comparator 34 to the charge-pump 33 if the input signal "IN" leads the output signal "OUT" in phase. By contrast, a signal "DOWN" is supplied from the phase comparator 34 to the charge-pump 33 if the output signal "OUT" leads the input signal "IN" in phase. The signal "UP" or the signal "DOWN" is supplied for a predetermined time corresponding to the phase difference between the input signal "IN" and the output signal "OUT." After that, the pump current is generated by the charge-pump 33 to the loop filter 32 on the basis of the signal "UP" or the signal "DOWN" from the phase comparator 34. In the loop filter 32, the pump current is smoothed to be supplied as the control voltage to the voltage-controlled oscillator 34. The voltage-controlled oscillator 34 is controlled by the control voltage to supply an electric signal to the next stage.

As explained above, the output signal of the voltage-controlled oscillator 31 is negatively fed back to the phase comparator 34 by a feedback control and a signal is handled by phase-lock loop circuit to be applied the control voltage to voltage-controlled oscillator 31 so that the phase of the output signal "OUT" approaches the phase of the input signal "IN" until the both correspond to each other.

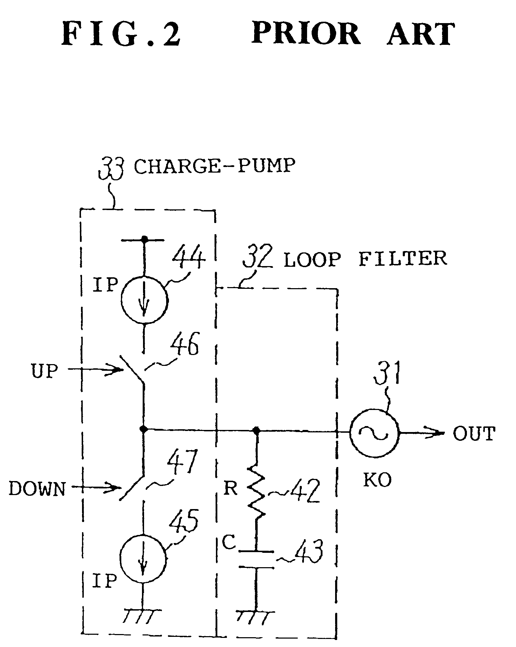

Fig. 2 shows in further detail the charge-pump 33 and the loop filter 32 shown in Fig. 1. Referring to Fig. 2, the charge-pump 33 comprises current sources 44 and 45, a first switch 46 controlled by the signal "UP" from the phase comparator 34 and the second switch 47 controlled by the signal "DOWN" from the phase comparator 34. The loop filter also comprises a resister 42 having a resistance R and a capacitor 43 having a capacitance C, both of which are connected in series.

In operation, when the signal "UP" is supplied from the phase comparator 34 to the charge-pump 33 since the input signal "IN" leads the output signal "OUT" in phase, the first switch 46 is turned on, thus supplying the positive pump current "IP" from the current source IP 44 to the resister 42 and the capacitor 43. During supplying the positive pump current "IP" thereto, the voltage of IP × R volts which is in the form of a square wave occurs across the resister 42 and an integrated voltage which has the slope of IP/C also occurs across the capacitor 43, respectively. Therefore, the positive voltage as the control signal, which is added to each voltage occurred across the resister 42 and the capacitor 43, is applied to control the voltage-controlled oscillator 31.

On the other hand, when the signal "DOWN" is supplied from the phase comparator 34 to the charge-pump 33 since the output signal "OUT" leads the input signal "IN" in phase, the second switch 47 is turned on, thus supplying the negative pump current "IP" from the current source 45 to the resister 42 and the capacitor 43. During supplying the negative pump current "IP" thereto, the voltage of -IP × R volts which are in the form of a square wave are occurred across the resister 42 and an integrated voltage which has the slope of -IP/C is also occurred across the capacitor 43, respectively. Therefore, the negative voltage as the control signal, which is added each voltage occurred across the resister 42 and the capacitor 43, is applied to control the voltage-controlled oscillator 31.

As explained above, the charge-pump phase-lock loop circuit performs as a loop filter on the basis of the integration due to the current sources 44 and 45 and the capacitor 43. In this charge-pump phase-lock loop circuit, the order of the loop is the second order because of being connected the resister 42 to the capacitor 43 in series. A natural frequency $\omega_n$ and a damping factor $\xi$ which are important to decide a features of the phase-lock loop circuit are defined by

$$\omega_n = \sqrt{\frac{KO \times IP}{2\pi C}} \qquad \ldots\ldots (1)$$

$$\xi = \frac{R \times C}{2} \times \omega_n \qquad \qquad \cdots \cdots (2)$$

where KO is the gain of the voltage-controlled oscillator 31.

However, the conventional charge-pump phase-lock loop circuit is engaged with disadvantages as follows. In the phase-lock loop of the second order, when the damping factor $\xi$ is less than 1, a ringing occurs in the output of the phase-lock loop circuit because of lack of damping. Thus, the value of the damping factor $\xi$ is usually set up 1.4 to 2.0.

On the other hand, a bandwidth of the phase-lock loop is decided by the natural frequency $\omega_n$. The natural frequency $\omega_n$ is given by the following equation (3) on the basis of the equation 2.

$$\omega_n = \frac{2\xi}{R \times C} \qquad \qquad \cdots \cdots (3)$$

Thus, for obtaining the desired natural frequency $\omega_n$, the denominator of the equation 3, i.e., the product of $R \times C$, is used, because the damping factor $\xi$ is constant for prevention of the ringing occurred in the output as explained above. If the bandwidth of the phase-lock loop is required to be narrow, that is, the natural frequency $\omega_n$ is required to be small, the value of the product of $R \times C$ has to be large. To use of the resister having high resistance and the capacitor having high capacitance in the integrated circuits, however, there is a serious problem, because most of the chip area of the integrated circuit is occupied by them.

Accordingly, it is an object of the invention to provide a novel charge-pump phase-lock loop circuit.

It is a further object of the invention to provide a charge-pump phase-lock loop circuit which can be readily obtained a desired natural frequency $\omega_n$ and damping factor $\xi$.

It is a still further object of the invention to provide a charge-pump phase-lock loop circuit which can be readily constructed by use of a small resistance and capacitance as compared with a conventional charge-pump phase-lock loop circuit.

The above and other objects, features and advantages of the present invention will be apparent from the following descriptions.

In accordance with the invention, there is provided a circuitry comprising a first element for oscillating an electric signal, a second element being electrically connected to the first element for fetching the electric signal from the first element and subsequent comparison in phase of an external input signal with the electric signal for generation of a detecting signal according to a result of the comparison, a third element including first and second current sources being electrically connected in parallel to the second element for fetching the detecting signal from the second element and subsequent generation of first and second pump currents by the first and second current sources respectively on the basis of the detecting signal and a fourth element being electrically connected to the first element and the third element for fetching the pump currents from the third element and subsequent smoothing of the pump current to be supplied to the first element thereby controlling the electric signal to match the electric signal to the external input signal by a negative feedback.

In the circuitry, each of the first and second current sources includes at least two current sources for generating a positive or negative pump current and includes at least two switches for the two current sources and the switches are controlled to turn on or off by the detecting signal.

The fourth element includes first and second input terminals connected to the first and second current sources respectively. Also, the fourth element includes a resister being electrically connected to the first input terminal for fetching the first pump current from the first current source, a capacitor being electrically connected to the second terminal for fetching the second pump current from the second current source and subsequent integration of the second pump current and an adder being electrically connected to the resister and the capacitor for adding a voltage across the resister to a voltage across the capacitor. Further, the fourth element includes a resister having one end being electrically connected to the first terminal for fetching the first pump current from the first current source, a capacitor having one end being electrically connected to the second input terminal for fetching the second pump current from the second current source and subsequent integration of the second pump current and an operational amplifier including a non inverting input being electrically connected to the one end of the resister, an inverting input being electrically connected to the one end of the capacitor and an output terminal being electrically connected to

EP 0 642 227 A1

the opposite end of the capacitor for fetching and subsequent addition of voltages across the resister and the capacitor.

In the circuitry, a ratio of the first pump current to the second pump current is controlled by the first and second current sources respectively to obtain a required natural frequency of the circuitry.

In accordance with the invention, there is, further, provided a pump circuit comprising at least one input terminal for fetching an electric signal, a first pump circuit being electrically connected to the input terminal, the first pump circuit including at least one current source for generating a first pump current, a second pump circuit being electrically connected to the input terminal, the second pump circuit including at least one current source for generating a second pump current and at least two output terminal being electrically connected to the first and second pump circuits, wherein the first and second pump circuits are electrically connected in parallel to the input terminal.

In accordance with the invention, there is, still further, provided a loop filter comprising first and second input terminals for fetching electric signals respectively, a resister having one end being electrically connected to the first input terminal for fetching the electric signal from the first input terminal, a capacitor having one end being electrically connected to the second input terminal for fetching the electric signal from the second input terminal and subsequent integration of the electric signal, an adder having one end being electrically connected to both the one end of the resister and the capacitor for fetching voltages across the resister and capacitor from the resister and the capacitor and subsequent addition of the voltages and an output terminal being electrically connected to the adder for fetching the added voltage from the adder, wherein the resister and capacitor are connected in parallel to the first and second input terminals respectively.

In accordance with the invention, there is, still further, provided a loop filter comprising, first and second input terminals for fetching electric signals respectively, a resister having one end being electrically connected to the first input terminal for fetching the electric signal from the first input terminal, a capacitor having one end being electrically connected to the second input terminal for fetching the electric signal from the second input terminal and subsequent integration of the electric signal, an operational amplifier including a non inverting input being electrically connected to the one end of the resister, an inverting input being electrically connected to the one end of the capacitor and an output terminal being electrically connected to other end of the capacitor for fetching voltages across the resister and the capacitor and subsequent addition of the voltages and an output terminal being electrically connected to the output terminal of the operational amplifier for fetching the added voltage from the operational amplifier.

Preferred embodiments of the present invention will hereinafter fully be described in detail with reference to the accompanying drawings.

Fig. 1 is a block diagram showing the conventional charge-pump phase-lock loop circuit.

Fig. 2 is a circuit diagram showing a charge-pump and a loop filter included in the conventional charge-pump phase-lock loop circuit as shown in Fig. 1.

Fig. 3 is a circuit diagram showing a charge-pump phase-lock loop circuit of the first embodiment according to the invention.

Fig. 4 is a circuit diagram showing a charge-pump phase-lock loop circuit of the second embodiment according to the invention.

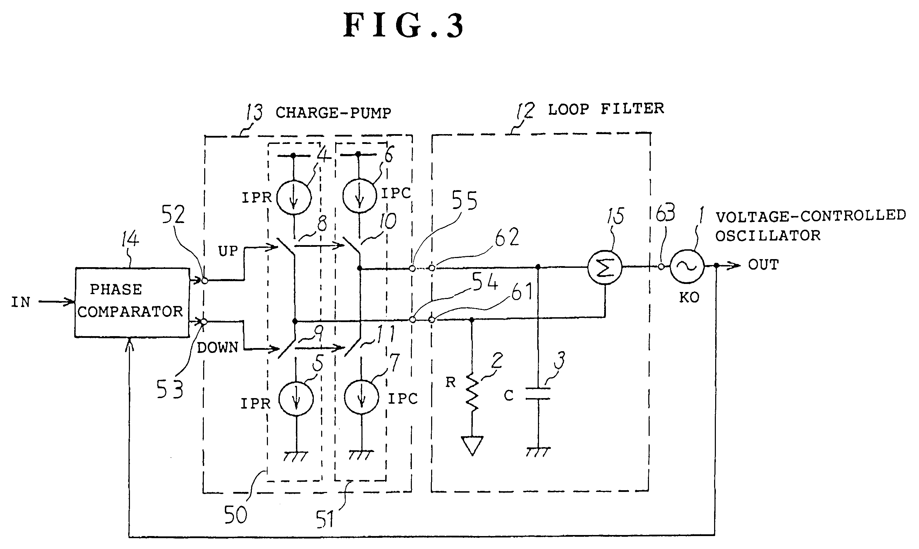

A first embodiment according to the invention will be described with reference to Fig. 3.

Referring to Fig. 3, a charge-pump phase-lock loop circuit of the first embodiment comprises a voltage-controlled oscillator 1 controlled by a control voltage, a phase comparator 14 for detecting a difference in phase between an external input signal "IN" and an output signal "OUT" of the voltage-controlled oscillator 1 to generate an "UP" signal or a "DOWN" signal, a charge-pump 13 for generating a pump current on the basis of the "UP" or "DOWN" signal of the phase comparator 14 and loop filter 12 for smoothing the pump current supplied from the charge-pump 13 to generate the control voltage for the voltage-controlled oscillator 1.

In the charge-pump phase-lock loop circuit of the first embodiment, the charge-pump 13 comprises the first and second charge-pumps 50 and 51, both of which are connected in parallel. The first charge-pump 51 comprises current sources 4 and 5 supplying the first pump current "IPR" to the loop filter 12 and switches 8 and 9 controlled by the signal from the phase comparator 14 and also the second charge-pump 51 comprises current sources 6 and 7 supplying the second pump current "IPC" to the loop filter 12 and switches 10 and 11 also controlled by the signal of the phase comparator 14.

Further, the loop filter 12 comprises a resister 2 having a resistance R connected to the current sources 4 and 5 through an input terminal 61, a capacitor 3 having a capacitance C connected to the current sources 6 and 7 through an input terminal 62 and an adder 15 for adding a voltage across the resister 2 and a voltage across the capacitor 3.

4

In operation, an external input signal "IN" and an output signal "OUT" from the voltage-controlled oscillator 1 are compared by the phase comparator 14. As a result of the comparison, a signal "UP" is supplied from the phase comparator 14 to the charge-pump 13 through an input terminal 52 if the input signal "IN" leads the output signal "OUT" in phase, in which the signal "UP" is supplied for a predetermined time corresponding to the phase difference between the input signal "IN" and the output signal "OUT."

When the signal "UP" is supplied from the phase comparator 14 to the charge-pump 13, the switches 8 and 10 are turned on, thus supplying the positive first pump current "IPR" from the current sources 4 to the resister 2 through an output terminal 54 and supplying the positive second pump current "IPC" from the current sources 6 to the capacitor 3 though an output terminal 55. During supplying the pump currents "IPR" and "IPC" thereto, the voltage of IPR $\times$ R volts which is in the form of a square wave occurs across the resister 2 and an integrated voltage which has the slope of IPC/C also occurs across the capacitor 3, respectively.

Subsequently, both the voltage occurred across the resister 2 and the voltage occurred across the capacitor 3 are added by the adder 15 and the added voltage is applied to the voltage-controlled oscillator 1 through an output terminal 63 as a control voltage. Therefore, the electric signal, phase of which corresponds to that of the input signal "IN," is applied to the next stage by the voltage-controlled oscillator 1.

In contrast, as a result of the comparison in the phase comparator 14, a signal "DOWN" is supplied from the phase comparator 14 to the charge-pump 13 through an input terminal 53 if the output signal "OUT" leads the input signal "IN" in phase, in which the signal "DOWN" is supplied for a predetermined time corresponding to the phase difference between the input signal "IN" and the output signal "OUT."

When the signal "DOWN" is supplied from the phase comparator 14 to the charge-pump 13, the switches 9 and 11 are turned on, thus supplying the negative first pump current "IPR" from the current sources 5 to the resister 2 through an output terminal 54 and supplying the negative second pump current "IPC" from the current sources 7 to the capacitor 3 through an output terminal 55. During supplying the pump currents "IPR" and "IPC" thereto, the voltage of -IPR $\times$ R volts which is in the form of a square wave occurs across the resister 2 and an integrated voltage which has the slope of -IPC/C also occurs across the capacitor 3, respectively.

Subsequently, both the voltage occurred across the resister 2 and the voltage occurred across the capacitor 3 are added by the adder 15 and the added voltage is applied to the voltage-controlled oscillator 1 through an output terminal 63 as a control voltage. Therefore, the electric signal, phase of which corresponds to that of the input signal "IN," is applied to the next stage by the voltage-controlled oscillator 1.

As explained above, the output signal of the voltage-controlled oscillator 1 is fed back to the phase comparator 14 by the feedback control and the signal is handled by the phase-lock loop to be applied the control voltage to voltage-controlled oscillator 1, so that the phase of the output signal "OUT" approaches the phase of the input signal "IN" until the both phases correspond to each other.

In the charge-pump phase-lock loop circuit of the first embodiment, a natural frequency $\omega_n$ and the damping factor $\xi$ which are important to decide the features of the phase-lock loop are defined by

$$\omega_n = \sqrt{\frac{KO \times IPC}{2\pi C}} \qquad \ldots\ldots(4)$$

$$\xi = \frac{R \times C}{2} \times \frac{IPR}{IPC} \times \omega_n \qquad \ldots\ldots(5)$$

where KO is the gain of the voltage-controlled oscillator 1.

Comparing the equation 2 with the equation 5, the pump current "IP" in the conventional charge-pump phase-lock loop circuit is divided into the pump current "IPR" and "IPC" in the first embodiment, so that a parameter is increased, i.e., IPR/IPC. Since the ratio of the current IPR to IPC (IPR/IPC) can suitably be selected in the charge-pump phase-lock loop circuit of the first embodiment, the desired natural frequency $\omega_n$ and damping factor $\xi$ can be obtained simultaneously with keeping the value of product of R $\times$ C in constant.

As explained above, according to the first embodiment, there is an effect in that the values of the resistance R and the capacitance C which dose not come into question in the integrated circuits can be selected, thus solving problems in the conventional charge-pump phase-lock loop circuit.

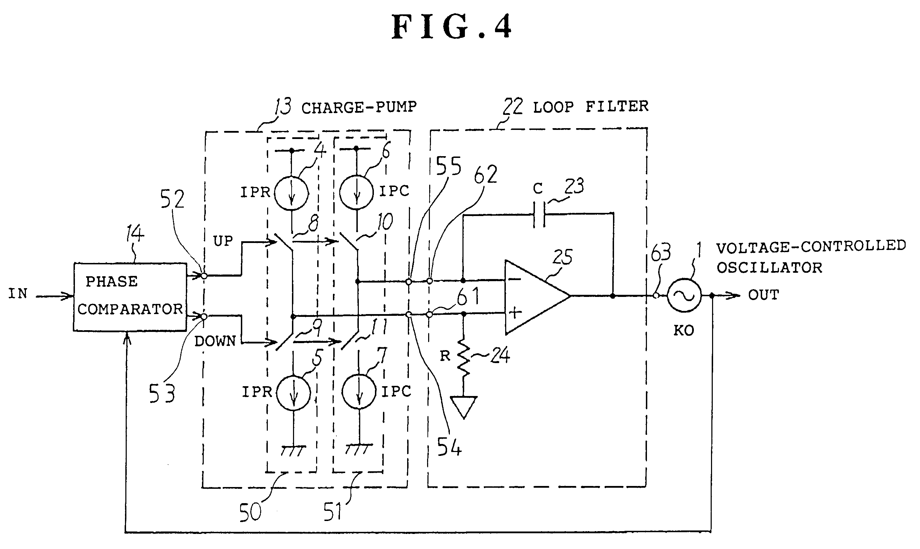

A second embodiment according to the invention will be described with reference to Fig. 4.

Referring to Fig. 4, a charge-pump phase-lock loop circuit of the second embodiment comprises a voltage-controlled oscillator 1 controlled by a control voltage, a phase comparator 14 for detecting a difference in phase between an external input signal "IN" and an output signal "OUT" of the voltage-controlled oscillator 1 to supply an "UP" signal and a "DOWN" signal, a charge-pump 13 for generating a pump current on the basis of the "UP" or "DOWN" signal of the phase comparator 14 and loop filter 22 for smoothing the current supplied from the charge-pump 13 to generate the control voltage for the voltage-controlled oscillator 1.

In the charge-pump phase-lock loop circuit of the second embodiment, the charge-pump 13 comprises the first and second charge-pumps 50 and 51, both of which are connected in parallel. The first charge-pump 50 comprises current sources 4 and 5 supplying the first pump current "IPR" and switches 8 and 9 controlled by the signal of the phase comparator 14 and also the second charge-pump 51 comprises current sources 6 and 7 supplying the second pump current "IPC" and switches 10 and 11 also controlled by the signal of the phase comparator 14.

Further, the loop filter 22 comprises a resister 24 having a resister R, one end of which is connected to the current sources 4 and 5 through an input terminal 61, a capacitor 23 having a capacitance C, one end of which is electrically connected to the current sources 6 and 7 through an input terminal 62 and an operational amplifier 25 including a non inverting input being connected to the one end of the resister 24, an inverting input being connected to the one end of the capacitor 23 and an output terminal being connected to the opposite end of the capacitor 23.

In operation, an external input signal "IN" and an output signal "OUT" from the voltage-controlled oscillator 1 are compared by the phase comparator 14. As a result of the comparison, a signal "UP" is supplied from the phase comparator 14 to the charge-pump 13 through an input terminal 52 if the input signal "IN" leads the output signal "OUT" in phase, in which the signal "UP" is supplied for a predetermined time corresponding to the phase difference between the input signal "IN" and the output signal "OUT."

When the signal "UP" is supplied from the phase comparator 14 to the charge-pump 13, the switches 8 and 10 are turned on, thus supplying the positive first pump current "IPR" from the current sources 4 to the resister 2 through an output terminal 54 and supplying the positive second pump current "IPC" from the current sources 6 to the capacitor 3 through an output terminal 55. During supplying the pump currents "IPR" and "IPC" thereto, the voltage of IPR × R volts which is in the form of a square wave is occurred across the resister 2 and an integrated voltage which has the slope of IPC/C also occurs across the capacitor 3, respectively.

Subsequently, both the voltage occurred across the resister 2 and the voltage occurred across the capacitor 3 are added by the operational amplifier 25 and the added voltage is applied to the voltage-controlled oscillator 1 as a control voltage. Therefore, the electric signal, phase of which corresponds to that of the input signal "IN," is applied to the next stage by the voltage-controlled oscillator 1.

In contrast, as a result of the comparison in the phase comparator 14, a signal "DOWN" is supplied from the phase comparator 14 to the charge-pump 13 through an input terminal 53 if the output signal "OUT" leads the input signal "IN" in phase, in which the signal "DOWN" is supplied for a predetermined time corresponding to the phase difference between the input signal "IN" and the output signal "OUT."

When the signal "DOWN" is supplied from the phase comparator 14 to the charge-pump 13, the switches 9 and 11 are turned on, thus supplying the negative first pump current "IPR" from the current sources 5 to the resister 2 through an output terminal 54 and supplying the negative second pump current "IPC" from the current sources 7 to the capacitor 3 through an output terminal 55. During supplying the pump currents "IPR" and "IPC" thereto, the voltage of -IPR × R volts which is in the form of a square wave occurs across the resister 2 and an integrated voltage which is the slope of -IPC/C also occurs across the capacitor 3, respectively.

Subsequently, both the voltage occurred across the resister 2 and the voltage occurred across the capacitor 3 are added by the operational amplifier 25 and the added voltage is applied to the voltage-controlled oscillator 1 as a control voltage. Therefore, electric signal, phase of which corresponds to that of the input signal "IN," is applied to the next stage by the voltage-controlled oscillator 1.

As explained above, the operational amplifier 25 in the loop filter 22 performs as an adder and an integrating circuit and the output of the operational amplifier 25 is the same as that of the loop filter 12 of the first embodiment. The output signal of the voltage-controlled oscillator 1 is, therefore, fed back to the phase comparator 14 by the feedback control and the signal is handled by phase-lock loop to apply the control voltage to voltage-controlled oscillator 1, so that the phase of the output signal "OUT" approaches the phase of the input signal "IN," until the both phases correspond to each other.

In the charge-pump phase-lock loop circuit of the second embodiment, a natural frequency $\omega_n$ and the damping factor $\xi$ which are important to decide the features of the phase-lock loop are also defined by

$$\omega_n = \sqrt{\frac{KO \times IPC}{2\pi C}} \qquad \ldots\ldots (6)$$

$$\xi = \frac{R \times C}{2} \times \frac{IPR}{IPC} \times \omega_n \qquad \ldots\ldots (7)$$

where KO is the gain of the voltage-controlled oscillator 1.

Comparing the equation 2 with the equation 7, the pump current "IP" in the conventional charge-pump phase-lock loop circuit is divided into the pump current "IPR" and "IPC" in the second embodiment, thus, a parameter is increased, i.e., IPR/IPC. Since the ratio of the current IPR to IPC (IPR/ IPC) can be suitably selected in the charge-pump phase-lock loop circuit of the second embodiment, the desired natural frequency $\omega_n$ and damping factor $\xi$ can be obtained simultaneously with keeping the value of product of R $\times$ C in constant.

As explained above, according to the second embodiment, there is an effect in that the values of the resistance R and the capacitance C which dose not come into question in the integrated circuits can be selected, thus solving problems in the conventional charge-pump phase-lock loop circuit.

In the first and second embodiments, although the phase comparator 14 is used for detecting the phase difference between the input signal "IN" and the output signal "OUT" of the voltage-controlled oscillator 1, the phase comparator 14 may be replaced by a phase/frequency detector. If the phase/frequency detector is used in the charge-pump phase-lock loop circuit, the operation of the charge-pump phase-lock loop circuit is in the following.

In operation, a difference in frequency between the input signal "IN" and the output signal "OUT" is detected by the phase/frequency detector (not shown). If the frequency of the input signal "IN" is higher than that of the output signal "OUT," the signal "UP" is supplied to the charge-pump 13 from the phase/frequency detector and the positive current is supplied to loop filter 12 or 22, consequently the control voltage for increasing an oscillating frequency is applied to the voltage-controlled oscillator 1 from the loop filter 12 or 22. If the frequency of the output signal "OUT" is higher than that of the input signal "IN," the operation in the charge-pump phase-lock loop circuit is the same as the above.

After that, a difference in phase between the input signal "IN" and the output signal "OUT" is detected by the phase/frequency detector, thus being in phase with each other on the basis of the operation as described in the embodiment 1 and 2.

Whereas modifications of the present invention will no doubt be apparent to a person of ordinary skilled in the art to which the invention pertains, it is to be understood that the embodiments shown and described by way of illustration are by no means intended to be considered in a limiting sense. Accordingly, it is to be intended by the claims to cover all modifications of the invention which fall within the spirit and scope of the invention.

**Claims**

1.  A circuitry comprising a first means (1) for oscillating an electric signal, a second means (14) being electrically connected to said first means (1) for fetching said electric signal from said first means (1) and subsequent comparison in phase of an external input signal with said electric signal for generation of a detecting signal according to a result of said comparison, a third means (13) being electrically connected to said second means (14) for fetching said detecting signal from said second means (14) and subsequent generation of a pump current on the basis of said detecting signal and a fourth means (12, 22) being electrically connected to said first means (1) and said third means (13) for fetching said pump currents from said third means (13) and subsequent smoothing of said pump current to be supplied to said first means (1) thereby controlling said electric signal to match said electric signal to said external input signal by a negative feedback, characterized in that said third means (13) includes first and second current sources (50, 51) being electrically connected in parallel to said second means (14) for fetching said detecting signal from said second means (14) and subsequent generation of first and second pump currents by said first and second current sources (50, 51) respectively on the basis of said detecting signal.

2. A circuitry as claimed in claim 1, characterized in that each of said first and second current sources (50, 51) includes at least two current sources (4, 5, 6, 7) for generating a positive or negative pump current.

3. A circuitry as claimed in claim 2, characterized in that each of said first and second current sources (50, 51) includes at least two switches (8, 9, 10, 11) for said two current sources (4, 5, 6, 7) and said switches (8, 9, 10, 11) are controlled to turn on or off by said detecting signal.

4. A circuitry as claimed in claim 1, characterized in that said fourth means (12, 22) includes first and second input terminals (61, 62) connected to said first and second current sources (50, 51) respectively.

5. A circuitry as claimed in claim 4, characterized in that said fourth means (12) includes a resister (2) being electrically connected to said first input terminal (61) for fetching said first pump current from said first current source (50), a capacitor (3) being electrically connected to said second terminal (62) for fetching said second pump current from said second current source (51) and subsequent integration of said second pump current and an adder (15) being electrically connected to said resister (2) and said capacitor (3) for adding a voltage across said resister (2) to a voltage across said capacitor (3).

6. A circuitry as claimed in claim 5, characterized in that a ratio of said first pump current to said second pump current is controlled by said first and second current sources (50, 51) respectively to obtain a required natural frequency of said circuitry.

7. A circuitry as claimed in claim 4, characterized in that said fourth means (22) includes a resister (24) having one end being electrically connected to said first terminal (61) for fetching said first pump current from said first current source (50), a capacitor (23) having one end being electrically connected to said second input terminal (62) for fetching said second pump current from said second current source (51) and subsequent integration of said second pump current and an operational amplifier (25) including a non inverting input being electrically connected to said one end of said resister (24), an inverting input being electrically connected to said one end of said capacitor (23) and an output terminal being electrically connected to the opposite end of said capacitor (23) for fetching and subsequent addition of voltages across said resister (24) and said capacitor (23).

8. A circuitry as claimed in claim 7, characterized in that a ratio of said first pump current to said second pump current is controlled by said first and second current sources (50, 51) respectively to obtain a required natural frequency of said circuitry.

9. A circuitry as claimed in claim 1, characterized in that said first means (1) is a voltage-controlled oscillator.

10. A circuitry as claimed in claim 1, characterized in that said second means (14) is a phase comparator.

11. A circuitry as claimed in claim 1, characterized in that said second means (14) is a phase/frequency detector.

12. A pump circuit comprising two current sources for generating a pump current and two switches connected to said two current sources respectively for turning on or off said two current sources on the basis of an electric signal, characterized in that said pump circuit comprises at least one input terminal (52, 53) for fetching an electric signal, a first pump circuit (50) being electrically connected to said input terminal (52, 53), said first pump circuit (50) including at least one current source (4, 5) for generating a first pump current, a second pump circuit (51) being electrically connected to said input terminal (52, 53), said second pump circuit (51) including at least one current source (6, 7) for generating a second

8

pump current and at least two output terminal (55, 54) being electrically connected to said first and second pump circuits (50, 51), wherein said first and second pump circuits (50, 51) are electrically connected in parallel to said input terminal (52, 53).

13. A pump circuit as claimed in claim 10, characterized in that said input terminal (52, 53) includes two input terminals (52, 53) being electrically connected to said first and second pump circuits (50, 51) respectively.

14. A pump circuit as claimed in claim 10, characterized in that said first and second pump circuits (50, 51) include two current sources (4, 5, 6, 7) respectively for generation of a positive or negative pump current.

15. A pump circuit as claimed in claim 12, characterized in that said first and second pump circuits (50, 51) include two switches (8, 9, 10, 11) corresponding to said two current sources (4, 5, 6, 7) for turning on or off said two current sources (4, 5, 6, 7) respectively.

16. A pump circuit as claimed in claim 10, characterized in that said output terminal (54, 55) includes two output terminals (54, 55) being electrically connected to first and second pump circuits (50, 51) respectively.

17. A loop filter comprising a resister and a capacitor, both of which are connected in series, for smoothing an electric signal, characterized in that said loop filter comprises first and second input terminals (61, 62) for fetching electric signals respectively, a resister (2) having one end being electrically connected to said first input terminal (61) for fetching said electric signal from said first input terminal (61), a capacitor (3) having one end being electrically connected to said second input terminal (62) for fetching said electric signal from said second input terminal (62) and subsequent integration of said electric signal, an adder (15) having one end being electrically connected to both said one end of said resister (2) and said capacitor (3) for fetching voltages across said resister (2) and capacitor (3) from said resister (2) and said capacitor (3) and subsequent addition of said voltages and an output terminal (63) being electrically connected to said adder (15) for fetching said added voltage from said adder (15), wherein said resister (2) and capacitor (30) are connected in parallel to said first and second input terminals (61, 62) respectively.

18. A loop filter comprising a resister and a capacitor, both of which are connected in series, for smoothing an electric signal, characterized in that said loop filter comprises first and second input terminals (61, 62) for fetching electric signals respectively, a resister (24) having one end being electrically connected to said first input terminal (61) for fetching said electric signal from said first input terminal (61), a capacitor (23) having one end being electrically connected to said second input terminal (62) for fetching said electric signal from said second input terminal (62) and subsequent integration of said electric signal, an operational amplifier (25) including a non inverting input being electrically connected to said one end of said resister (24), an inverting input being electrically connected to said one end of said capacitor (23) and an output terminal being electrically connected to other end of said capacitor (63) for fetching voltages across said resister (24) and said capacitor (23) and subsequent addition of said voltages and an output terminal (63) being electrically connected to said output terminal of said operational amplifier (25) for fetching said added voltage from said operational amplifier (25).

# FIG.1 PRIOR ART

IN → | PHASE COMPARATOR | 34

SIGNAL "UP"

SIGNAL "DOWN"

CHARGE-PUMP | 33

LOOP FILTER | 32

KO | 31

→ OUT

# F I G . 2    PRIOR ART

33 CHARGE-PUMP

32 LOOP FILTER

# FIG.3

1 VOLTAGE-CONTROLLED OSCILLATOR

OUT

KO

63

15

12 LOOP FILTER

62 55 54 61

3

C

R

2

13 CHARGE-PUMP

6 IPC 10

4 8

11 7 IPC

9 5

51

IPR

UP

DOWN

IPR

50

52 53

14 PHASE COMPARATOR

IN

12

# FIG.4

13 CHARGE-PUMP

22 LOOP FILTER

PHASE COMPARATOR

14

52

53

UP

DOWN

IN

4 IPR

6 IPC

8

10

5 IPR

7 IPC

9

11

50

51

55

62

C 23

25

R 24

61

54

63

1 VOLTAGE-CONTROLLED OSCILLATOR

KO

OUT

EP 0 642 227 A1

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US-A-5 121 085 (BROWN)<br>* column 4, line 61 - column 10, line 27; figures 2,3A,3B * | 1-16 | H03L7/089<br>H03L7/093 |
| X | US-A-5 008 637 (RAY)<br>* column 3, line 31 - column 4, line 68; figures 2,3,5 * | 1-5,9-17 | |
| X | WO-A-93 03545 (SEIKO EPSON CORPORATION)<br>* abstract; figure 1 * | 1-4,9-16 | |
| A | & US-A-5 319 320 | 5,6,8 | |
| X | EP-A-0 369 858 (THOMSON CSF)<br>* figures 1,4 * | 18 | |

TECHNICAL FIELDS SEARCHED     (Int.Cl.6)

H03L
H03D

The present search report has been drawn up for all claims

| Place of search | Date of completion of the search | Examiner |
|---|---|---|
| THE HAGUE | 17 October 1994 | Balbinot, H |

EPO FORM 1503 03.82 (P04C01)